# EUROPEAN PATENT APPLICATION

(11) **EP 0 965 304 A1**
(43) Date of publication of application: **22.12.1999**
(21) Application number: 97949247.7
(22) Date of filing: 26.12.1997
(51) Int. Cl.: A61B 5/055, G01R 33/383

(54) **MRI MAGNETIC FIELD GENERATOR**

(71) Applicant: SUMITOMO SPECIAL METALS COMPANY LIMITED, Osaka-shi, Osaka 541-0041 (JP)
(72) Inventor: SAKURAI, Hideya, Mishima-gun, Osaka 618 (JP); AOKI, Masaaki, Osaka 569-11 (JP)
(74) Representative: Jackson, Peter
(86) International application number: JP9704868
(87) International publication number: WO9933398

(57) **Abstract**

An object of the present invention is to provide an MRI magnetic field generator with a structure that makes it possible to obtain a uniform static magnetic field stably within the imaging space, without making the patient feel confined, despite the structure being compact and low-cost, and that yields a sharp image with high resolution. Magnetic field boosting coils 14 are wound around the peripheral edges of a pair of magnetic pole pieces that face each other so as to form an air gap, which makes it possible to increase or decrease the magnetic field intensity with a simple construction, without having to modify the shape of the magnetic circuit or increase the weight or surface area of the magnets. Also, the magnetic field distribution can be adjusted by adjusting the direction of the current flowing to the coils, which enhances magnetic field uniformity.

## Description

### TECHNICAL FIELD

This invention relates to an improvement to a magnetic field generator used, for example, in medical-use magnetic resonance imaging devices (hereinafter referred to as MRI devices), and more particularly to an MRI magnetic field generator that generates a powerful, precise, and uniform magnetic field within an air gap as a result of magnetic field adjusting coils being wound around the peripheral edges of a pair of magnetic pole pieces that face each other so as to form an air gap.

### BACKGROUND ART

An MRI device is a device with which all or part of a patient's body is inserted into the air gap of a magnetic field generator that forms a powerful magnetic field, and a tomographic image is obtained so that the tissue thereof can be evaluated. This MRI magnetic field generator has to be wide enough for all or part of a patient's body to be inserted, and to obtain a sharp tomographic image it is usually necessary to form a stable, powerful, and uniform magnetic field having a precision of 1 × 10⁻⁴ or less and 0.02 to 2.0 T within the imaging field of view in the air gap.

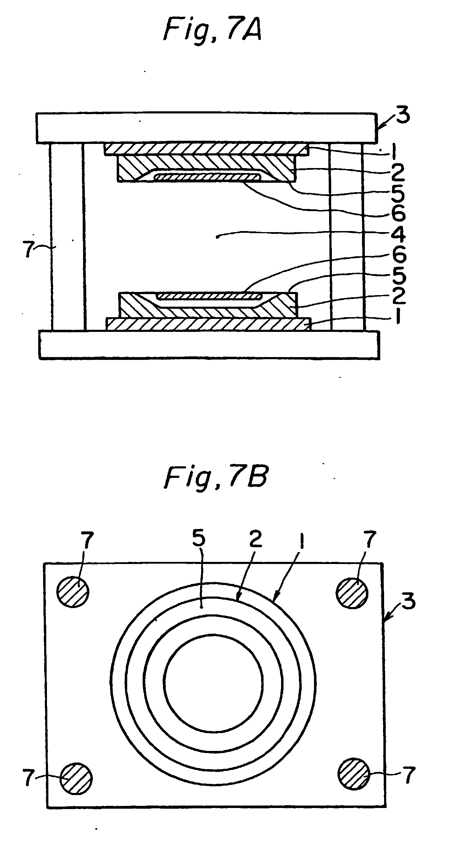

As shown in Figures 7A and 7B, one known magnetic field generator used in MRI devices has a structure in which magnetic pole pieces 2 are fixed facing each other at one end of each of a pair of permanent magnet structures 1 in which an R-Fe-B-based magnet is used as the magnetic field generation source, the other ends are coupled by a yoke 3, and a static magnetic field is generated within an air gap 4 between the magnetic pole pieces 2 (Japanese Patent Publication 2-23010). Providing annular protrusions 5 around the periphery of the magnetic pole pieces 2 in order to increase the uniformity of the magnetic field distribution within the air gap 4, providing a convex protrusion (not shown) in the center (Japanese Utility Model Publication 5-37446), and other such structures have been employed, and [these components] are usually made from a sheet-form bulk material produced by planing down electromagnetic soft iron, pure iron, or another magnetic material. In the figure, 6 is a gradient coil.

However, with the above-mentioned magnetic field generators, the magnetic flux is prone to leaking from the magnetic poles into the air gap, so that along the vertical center line of the air gap, the magnetic field intensity is higher closer to the magnetic pole surfaces. Consequently, in order to obtain a magnetic field of the desired high intensity and uniformity within the usage magnetic field space, the air gap has to be several times [as large as] the usage magnetic field space, which is accomplished, for example, by using a large quantity of costly permanent magnets or increasing the distance between the magnetic poles or the surface area of the magnetic poles, but this results in a larger magnetic circuit and drives up the cost as well.

In view of this, the applicant discovered that the magnetic field generator can be made more compact by using a magnetic field generation source comprising an arrangement of permanent magnets whose primary phase is composed of tetragonal crystals and whose primary components are 8 to 30 at% R (where R is one or more types of rare earth elements including Y), 2 to 28 at% B, and 42 to 90 at% Fe, and applying these permanent magnets to a magnetic field generator, and that, because of the temperature characteristics of these permanent magnets, by keeping these permanent magnets cooled, a much higher maximum energy product can be obtained, and the magnet weight can be reduced further(Japanese Patent Publication 4-22009).

It was also discovered that the magnetic field intensity and the magnetic field uniformity within the magnetic circuit air gap can be increased and the region of uniform magnetic field can be expanded with high precision by disposing separate permanent magnet structures around flat permanent magnet structures so that the magnetic pole surfaces of a pair of permanent magnet structures form a concave curved surface with respect to the air gap (Japanese Patent Publication 3-20053).

However, the former invention required a cooling device, while the latter required a plurality of permanent magnet structures, both of which make the construction more complex, so assembly takes longer and the price is higher, among other problems.

Also, in an effort to enhance the uniformity of the magnetic field within the air gap, the applicant has proposed a structure in which at least one auxiliary permanent magnet having the same direction of magnetization as the permanent magnets is mounted inside and/or outside the permanent magnets such that it is movable in the direction of magnetization of the permanent magnets, which makes it possible to adjust the amount of magnetic flux generated in the air gap (Japanese Patent Publication 3-7124), and a structure in which magnetic force regulating rods composed of a magnetic material are provided to the yoke such that the amount they protrude into at least the air gap can be varied, which allows the amount of magnetic flux short-circuiting to be increased or decreased (Japanese Utility Model Publication 2-41841). Nevertheless, if the amount of short-circuiting of the magnetic flux is increased too much by these auxiliary permanent magnets or magnetic force regulating rods, there is the danger that this will lead to a decrease in magnetic field intensity.

Furthermore, in order to form a static magnetic field of high uniformity and stability, there has been proposed a nuclear magnetic resonance device with a structure in which there is a static magnetic field generation means comprising a pair of permanent magnets and a magnetic yoke that forms a nearly sealed space and magnetically couples these magnets, furnished with a plurality of auxiliary coils disposed in the vicinity of each of this pair of permanent magnets for correcting the uniformity of the above-mentioned static magnetic field, the current applied to these auxiliary coils being determined so as to cancel out the effect of the above-mentioned magnetic yoke on the magnetic field formed by the auxiliary coils and on the static magnetic field distribution of the permanent magnets (Japanese Laid-Open Patent Application 61-17053).

With the above structure, however, the pair of auxiliary coils are disposed on the side of each magnetic pole piece facing the air gap, and the air gap is narrowed by the disposition of these auxiliary coils. If the air gap is widened so that the patient will not feel so confined, the intensity of the static magnetic field will be weaker and a good quality image will not be obtained.

Furthermore, there is the problem that a conventional mechanical method for adjusting the magnetic field is inadequate if there should be a sudden dynamic change in the magnetic field intensity in the course of using the above-mentioned MRI magnetic field generator to produce an image due to a change in the magnet temperature, the movement of something such as an elevator in the building where the device is installed, or the movement of automobiles or trains in the vicinity of the building.

### DISCLOSURE OF THE INVENTION

This invention was proposed in light of the above situation in terms of the desired magnetic field intensity of an MRI magnetic field generator, and an object thereof is to provide an MRI magnetic field generator with a structure that makes it possible to obtain a uniform static magnetic field stably within the imaging space, without making the patient feel confined, despite the structure being compact and low-cost, and that yields a sharp image with high resolution.

As a result of various investigations aimed at achieving the stated object, the inventors perfected the present invention upon discovering that, in an MRI magnetic field generator having a pair of magnetic poles that face each other so as to form an air gap and that are magnetically coupled by a yoke, and generating a magnetic field in this air gap, the magnetic field intensity can be increased or decreased by mounting magnetic field adjusting coils around the peripheral edges of magnetic pole pieces installed at these magnetic poles and sending current to these coils, and that the magnetic field distribution can be adjusted and the magnetic field uniformity enhanced by adjusting the direction of the current.

The inventors also propose an MRI magnetic field generator structured as above, with a structure in which the magnetic pole pieces include annular protrusions and the magnetic field adjusting coils are wound around the peripheral edges of these annular protrusions, and, as the structure which makes possible the high-precision adjustment of the magnetic field distribution, a structure in which the annular protrusions comprise a plurality of arc-shaped annular protrusion members and the magnetic field adjusting coils are wound each of these annular protrusion members.

### BRIEF DESCRIPTION OF THE DRAWINGS

Figure 1 is diagrams illustrating an embodiment of the magnetic field generator pertaining to this invention, with 1A being a vertical cross section, and 1B an oblique view;
Figure 2 is a vertical cross section illustrating another embodiment of the magnetic field generator pertaining to this invention;
Figure 3 is an oblique view illustrating an embodiment of the split annular protrusions of the magnetic field generator pertaining to this invention;
Figure 4 is magnetic field distribution graphs in various planes when a spherical space is split into 15 horizontal planes, with 4A being a conventional magnetic field generator, and 4B the magnetic field generator pertaining to this invention;
Figure 5 is a top view of an embodiment of the split annular protrusions of the magnetic field generator pertaining to this invention;
Figure 6 is magnetic field distribution graphs in the X axial direction, with 6A being a conventional magnetic field generator, and 6B the magnetic field generator pertaining to this invention;
Figure 7 is a diagram illustrating the structure of a conventional MRI magnetic field generator, with 7A being a front view, and 7B a lateral cross section thereof;
Figure 8 is diagrams illustrating the structure of the magnetic pole pieces used in a conventional MRI magnetic field generator, with 8A being front view, and 8B a lateral cross section thereof; and
Figure 9 is diagrams illustrating the structure of a conventional MRI magnetic field generator, with 9A being front view, and 9B a lateral cross section thereof.

### BEST MODE FOR CARRYING OUT THE INVENTION

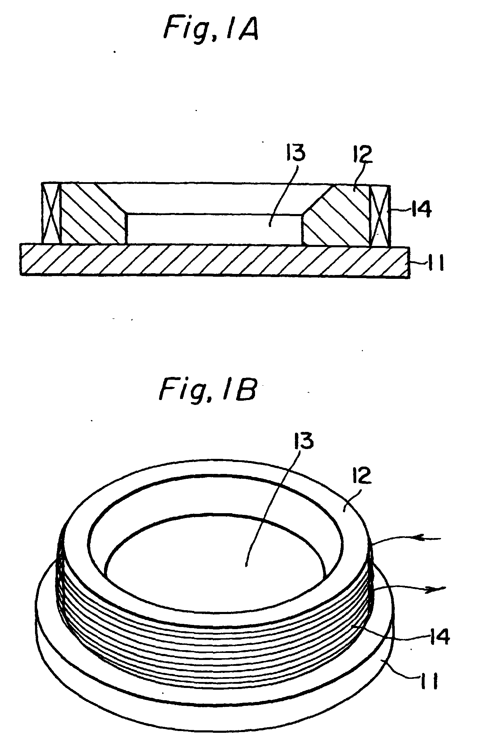

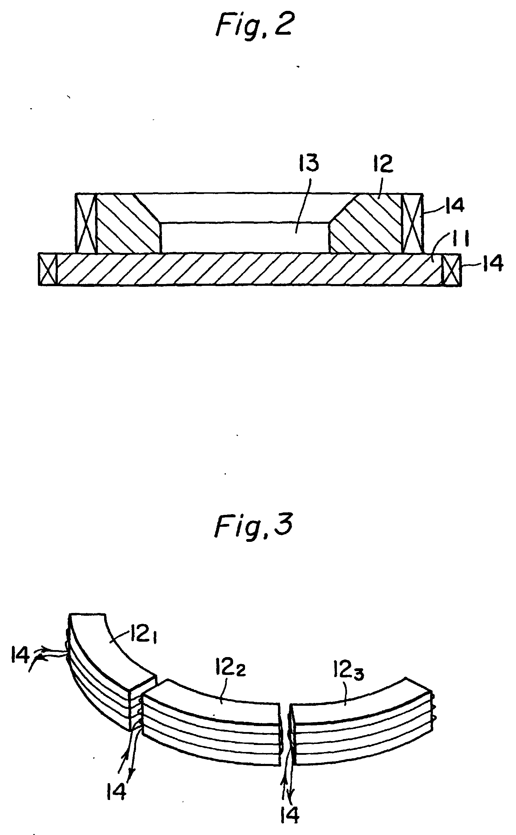

Figures 1A and 1B are a vertical cross section and an oblique view illustrating an embodiment of the magnetic field generator pertaining to this invention. For example, an annular protrusion 12 composed of layered silicon steel sheets with a pentagonal cross section is disposed on the air gap-facing side of a magnetic material base 11 composed of pure iron or the like. An internal magnetic pole piece 13 is disposed on the inside thereof, and a magnetic field adjusting coil 14 is wound around the peripheral edge of the annular protrusion 12. The object of this invention can also be achieved by a structure in which the internal magnetic pole piece 13 is not provided, the annular protrusion 12 is disposed directly on the magnetic material base 11, and the magnetic field adjusting coil 14 is wound around the peripheral edge thereof. As shown in Figure 2, the same effect as with the above-mentioned structure will also be obtained with a structure in which the magnetic field adjusting coil 14 is wound around the peripheral edge of the annular protrusion 12 that constitutes the magnetic material base 11 and the magnetic pole piece, or around the peripheral edge of the magnetic material base 11, the annular protrusion 12, and a permanent magnet structure.

A material known in the past as a magnetic pole piece, such as electromagnetic soft iron or pure iron, can be used for the magnetic material base that constitutes the magnetic pole piece in this invention. The magnetic material base makes the magnetic field intensity more uniform, ensures good mechanical strength of the magnetic pole piece as a whole, and facilitates the work of assembling the magnetic field generator.

The material that constitutes the magnetic pole pieces in this invention is not limited to the materials in the embodiments, and a material produced by molding pure iron or a soft magnetic powder with an electrically insulating material, or the like can be employed, but the generation of residual magnetism or the eddy current that is generated at the magnetic material base during the application of a pulsed magnetic field can be reduced by employing a laminate of silicon steel sheets or soft ferrite, such as one based on Mn-Zn or Ni-Zn, because of the low coercive force and the high electrical resistance thereof. Also, the advantages of laminated silicon steel sheets and soft ferrite can be taken advantage of more fully by using these materials together. Laminated silicon steel sheets are economically advantageous to soft ferrite because of their lower cost.

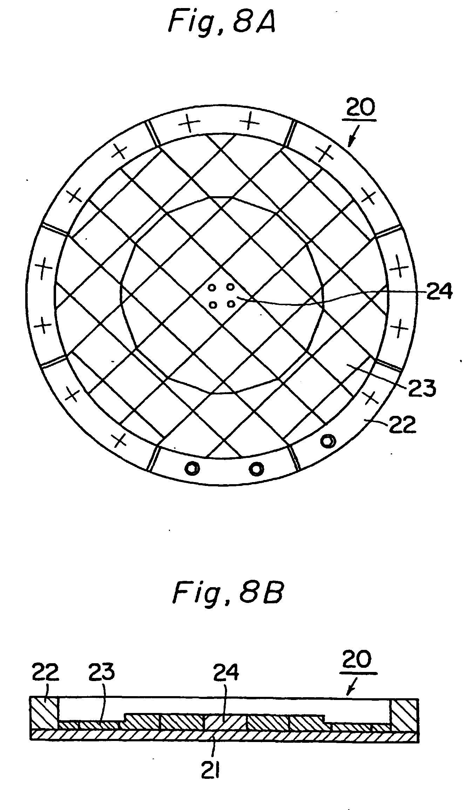

If the above-mentioned material is made into a plurality of block-like magnetic pole piece members 23 and 24 disposal of the material on the magnetic material base 21, as with the magnetic pole piece 20 shown in Figure 8, then the reduction in eddy current and residual magnetism will be better and the members can be attached with less work. Optimizing the thickness of the above-mentioned magnetic pole piece members 23 and 24 or the thickness ratio of the magnetic material base ensures that the magnetic pole piece 20 will have good mechanical strength, equalizes the magnetic field intensity required of the magnetic pole piece 20, and prevents eddy current and residual magnetism.

Furthermore, it is preferable in this invention to form protrusions consisting of a magnetic material ring 22, such as electromagnetic soft iron or pure iron, around the peripheral edges of the disk-shaped magnetic material bases 21 in order to increase the magnetic field uniformity within the air gap. It is preferable for these magnetic material rings to be electrically insulated from the magnetic material bases in order for the effect of the eddy current to be reduced. In particular, if one or more slits are provided in the circumferential direction, the effect of the eddy current can be diminished even further.

The cross section of the annular protrusions is suitably selected from among approximately triangular, trapezoidal, and the like. A similar effect will be obtained if the entire surface of the opposing sides of the magnetic pole pieces is a concave curved surface having a smooth curve with a single or complex radius of curvature.

In this invention, winding the magnetic field adjusting coils around the magnetic pole pieces including the above-mentioned annular protrusions and then passing current there through makes it possible to increase the magnetic field of the magnetic field generation source and raise or lower the magnetic field intensity, and particularly with a structure having annular protrusions on the magnetic pole pieces, winding the magnetic field adjusting coils around the peripheral edges of the magnetic pole pieces combines with the magnetic field equalization effect of the annular protrusions to produce an even more uniform magnetic field.

With a structure in which the annular protrusions are divided into a plurality of segments by the provision of a plurality of slits in the circumferential direction, the magnetic field adjusting coil 14 is wound around each of the segmented annular protrusions 121, 122, and 123 as shown in Figure 3, and the amount of current passing through each segment is adjusted, the advantage of which is that fine adjustments can be made to the magnetic field distribution.

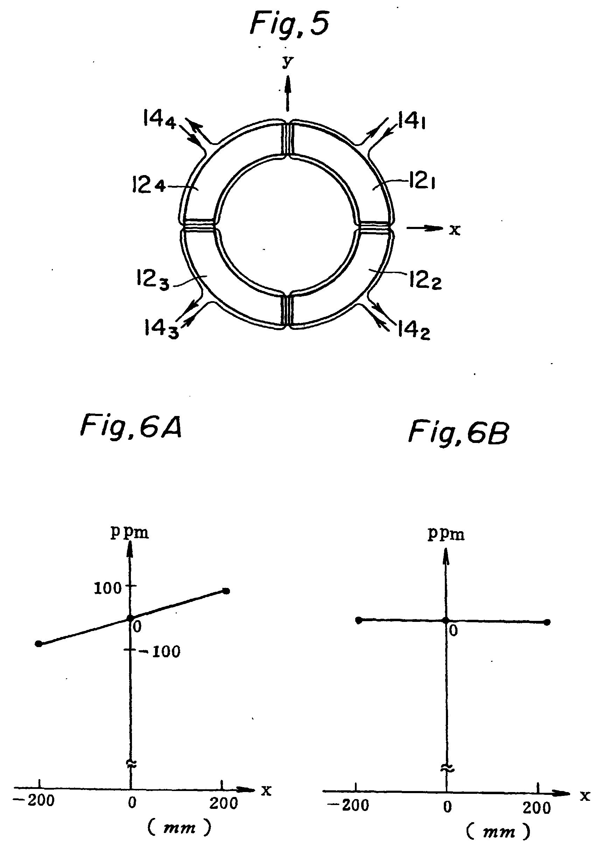

When the magnetic field distribution in the imaging space is asymmetrical in the positive and negative directions of the Y axis via the X axis, as shown in Figure 5, the magnetic field distribution can be adjusted and magnetic field uniformity enhanced by sending current to some of the magnetic field adjusting coils 143 and 144 on the magnetizing side and to other magnetic field adjusting coils 141 and 142 on the demagnetizing side.

When the MRI magnetic field generator of this invention structured as above is used, the magnetic field intensity can be raised or lowered by winding magnetic field adjusting coils around the peripheral edges of the magnetic pole pieces that have been used in the past, without greatly changing the shape of the magnetic circuit or increasing the weight or surface area of the magnets. Also, by adjusting the direction of current flowing to each of the magnetic field adjusting coils wound around the pair of magnetic pole pieces, the adjustment of the magnetic field distribution in the air gap can be accomplished more simply, which improves magnetic field uniformity.

Furthermore, with a structure in which a plurality of slits are provided to the annular protrusions in the circumferential direction thereof for the purpose of suppressing eddy current, and the arc-shaped annular protrusion structures are joined together, the magnetic field distribution can be finely adjusted by winding magnetic field adjusting coils around each of these annular protrusion structures and adjusting the flow of current through each one.

When an R-Fe-B-based permanent magnet is used as the magnetic field generation source, this rare earth magnet has a temperature coefficient of-0.1%/°C, but the magnetic pole pieces or the magnetic field adjusting coils wound around the peripheral edges of the permanent magnets or the magnetic pole pieces generate heat when current is continuously passed through, and this warms the permanent magnets, so the temperature of the magnets is maintained and the magnetic field intensity is stabilized.

Therefore, if a sensor is provided in the magnetic field, then when temperature changes cause the magnetic field intensity to vary, the magnetic field can be kept stable by passing current through the magnetic field adjusting coils. Even if the movement of an elevator or an automobile should interfere with the magnetic field during imaging, dynamic changes in the magnetic field can be corrected by the provision of the magnetic field adjusting coils of this invention.

The MRI magnetic field generator that is the subject of this invention is not limited to the embodiments given above, and can be applied to any structure as long as it is one in which a pair of magnetic poles that face each other so as to form an air gap are magnetically coupled by a yoke. Furthermore, the size and shape of the yokes used to form a magnetic path may be suitably selected as dictated by the required size of the air gap, the magnetic field intensity, the magnetic field uniformity, and various other variables.

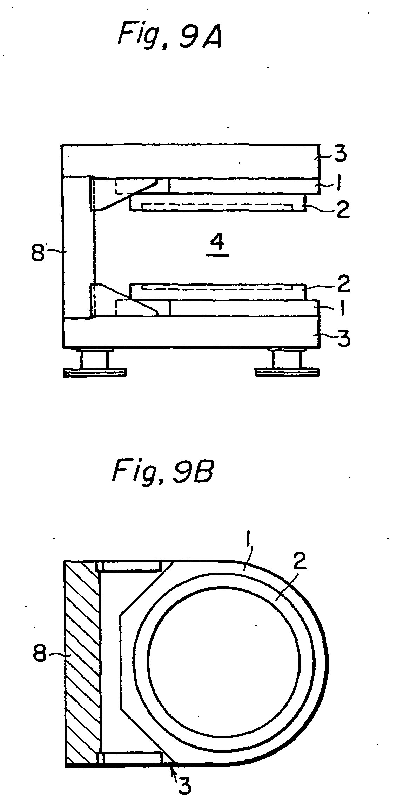

In addition to the above structure shown in Figures 7A and 7B, in which a pair of yokes 3 facing each other through an air gap were connected by four cylindrical yokes 7, it is also possible to employ the structure shown in Figures 9A and 9B, in which magnetic pole pieces 2 are fixed facing each other at one end of each of a pair of permanent magnet structures 1, and yokes 3 fixed at the other ends are coupled by a flat connecting yoke 8.

With the structure in Figures 9A and 9B, the yokes 3 are connected at one end by a single connecting yoke 8, and since the air gap 4 between the magnetic pole pieces 2 is open on three sides (closed only on the connecting yoke 8 side), the device has a more open feel, without confining the patient.

Normal conduction magnets, superconduction magnets, permanent magnets, and the like can be used as the magnet structures that serve as the magnetic field generation source, and when permanent magnets are employed, ferrite magnets, rare earth cobalt-based magnets, or other such known magnetic materials can be used. In particular, the device can be made much more compact by using light rare earths, which are a plentiful resource, with R primarily being Nd or Pr, and using an Fe-B-R-based permanent magnet that exhibits an extremely high energy product of over 30 MG0e as the main component. Also, by arranging a combination of these known permanent magnets, a magnetic field generator that is less expensive can be provided without greatly hindering efforts to make the device more compact.

### EMBODIMENTS

### Embodiment 1

Using Nd-Fe-B-based permanent magnets having a BHmax of 40 MG0e, an outside diameter of 1300 mm, an inside diameter of 190 mm, and a height of 150 mm in a magnetic field generator structured as shown in Figures 1A and 1B, an annular protrusion composed of low-carbon steel and having an outside diameter of 1200 mm, an inside diameter of 1000 mm, and a height of 70 mm was disposed on a magnetic material base composed of pure iron and having an outside diameter of 1200 mm and a height of 40 mm, and a silicon steel sheet laminate produced by laminating and integrating block-like silicon steel sheets in the opposing direction of the magnetic pole pieces, and having an outside diameter of 1000 mm and a height (in the center) of 25 mm, was provided inside the annular protrusion.

A pair of upper and lower annular protrusions were provided such that the distance between their opposing sides was 500 mm, magnetic field adjusting coils composed of electrical copper wire were wound around the peripheral edges of the annular protrusions for 1000 turns, a 10 A current was passed through one coil on the magnetization side (the same direction as the static magnetic field), and current was also passed through the other coil on the magnetization side (the same direction as the static magnetic field). This structure allowed the intensity at the center of the magnetic field to be increased approximately 120 Gauss.

The objective in this case is to strengthen the magnetic field in the center of the air gap, but when the objective is to correct changes in the magnetic field caused by the movement of automobiles or an elevator, the magnetic field can be corrected with fewer wire windings or a smaller current than those given above. In this case, the magnetic field uniformity within the air gap can be maintained by sensing the magnetic field from the outside by means of a magnetic sensor placed on the outside of the magnetic field generator, and raising or lowering the current flowing to the magnetic field adjusting coils according to this sensor information. The number of wire windings and the current value are suitably selected according to the desired magnetic field intensity and the portion to be corrected.

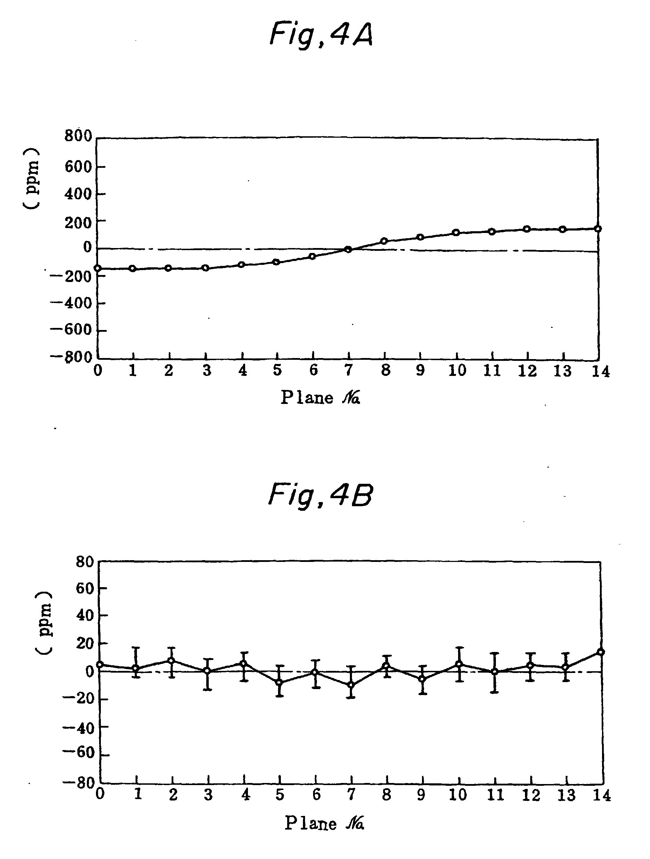

Assuming that the imaging space in the structure of Embodiment 1 is a sphere, Figure 4B illustrates the magnetic field distribution in various planes when this spherical space is split into 15 horizontal planes. Figure 4A shows the results of producing a conventional magnetic circuit with the same structure as in Embodiment 1 except that no magnetic field adjusting coils were provided, and examining the magnetic field distribution in the same manner as in Embodiment 1. As is clear from Figure 4, the structure of this invention greatly increased the uniformity of the magnetic field at a very low current value.

### Embodiment 2

As shown in Figures 3 and 5, a plurality of slits were provided to the annular protrusions in the circumferential direction thereof, the arc-shaped annular protrusion members were joined together, and a magnetic field adjusting coil was wound around each of these annular protrusion members. As shown in Figure 6B, the magnetic field uniformity is higher than when no magnetic field adjusting coils were provided, as shown in Figure 6A.

### INDUSTRIAL APPLICABILITY

With this invention, magnetic field adjusting coils are wound around the peripheral edges of a pair of magnetic pole pieces that face each other so as to form an air gap, and as a result it is possible to raise or lower the magnetic field intensity with a simple structure, without changing the shape of the magnetic circuit or increasing the weight or surface area of the magnets. Also, when the magnetic field distribution in the imaging space is vertically asymmetrical via the X axis, the magnetic field distribution can be adjusted by passing current though one coil in the opposite direction from that of the other coil, which increases magnetic field uniformity.

Furthermore, when a plurality of slits are provided to the annular protrusions of the magnetic pole pieces in the circumferential direction thereof for the purpose of suppressing eddy current, and the plurality of segmented annular protrusion members are joined together, the magnetic field distribution can be finely adjusted by winding magnetic field adjusting coils around each of these annular protrusion members and adjusting the flow of current though each one.

Finally, when rare earth magnets that are susceptible to the effect of the ambient temperature are used as the main magnetic field generation source, the temperature of the permanent magnets can be maintained by the heat generated as current flows though the magnetic field adjusting coils, which allows a stable and uniform magnetic field to be obtained. In addition, the magnetic field distribution can be instantly adjusted if there should be a dynamic change in the magnetic field intensity due to any cause whatsoever, such as the movement of automobiles or an elevator during imaging.

## Claims

1. An MRI magnetic field generator having a pair of magnetic poles that face each other so as to form an air gap and that are magnetically coupled by a yoke, and generating a magnetic field in said air gap, said MRI magnetic field generator comprising magnetic field adjusting coils wound around the peripheral edges of magnetic pole pieces disposed on said poles.

2. The MRI magnetic field generator according to claim 1, wherein the magnetic pole pieces include annular protrusions, and the magnetic field adjusting coils are wound around the peripheral edges of said annular protrusions.

3. The MRI magnetic field generator according to claim 1, wherein the magnetic pole pieces include annular protrusions and magnetic material bases, and the magnetic field adjusting coils are wound around the peripheral edges of said magnetic material bases.

4. The MRI magnetic field generator according to claim 1, wherein the magnetic pole pieces include annular protrusions and magnetic material bases, and the magnetic field adjusting coils are wound around the peripheral edges of said annular protrusions and around the peripheral edges of said magnetic material bases.

5. The MRI magnetic field generator according to claim 1, wherein the magnetic pole pieces include annular protrusions, magnetic material bases, and internal magnetic pole pieces, and the magnetic field adjusting coils are wound around the peripheral edges of said annular protrusions and around the peripheral edges of said magnetic material bases.

6. The MRI magnetic field generator according to claim 5, wherein the internal magnetic pole pieces are composed of silicon steel plates.

7. The MRI magnetic field generator according to claim 2, wherein the annular protrusions are composed of a plurality of arc-shaped annular protrusion members, and the magnetic field adjusting coils are wound around each of said annular protrusion members.

8. The MRI magnetic field generator according to claim 7, wherein the annular protrusions are composed of four arc-shaped annular protrusion members.

9. The MRI magnetic field generator according to any of claims 2 to 8, wherein at least part of the annular protrusions is formed from silicon steel.

10. The MRI magnetic field generator according to any of claims 1 to 9, wherein the pair of magnetic pole pieces are fastened to an upper yoke and a lower yoke, and the upper and lower yokes are magnetically coupled by a single connecting yoke.

11. The MRI magnetic field generator according to any of claims 1 to 9, wherein the pair of magnetic pole pieces are fastened to upper and lower yokes, and the upper and lower yokes are magnetically coupled by a plurality of connecting yokes.

12. The MRI magnetic field generator according to any of claims 1 to 9, wherein the pair of magnetic pole pieces are disposed facing each other within a tubular yoke and are magnetically coupled by said yoke.
